(19) Europäisches Patentamt / European Patent Office / Office européen des brevets

(11) **EP 2 615 612 B1**

(12) **FASCICULE DE BREVET EUROPEEN**

(45) Date de publication et mention de la délivrance du brevet:
**10.09.2014   Bulletin 2014/37**

(51) Int Cl.:
*G11C 13/00* *(2006.01)*      *H01L 45/00* *(2006.01)*

(21) Numéro de dépôt: **13354001.3**

(22) Date de dépôt: **07.01.2013**

(54) **Cellule mémoire à changement de phase**

Phasenänderungsspeicherzelle

Phase transition memory cell

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **12.01.2012   FR 1200094**

(43) Date de publication de la demande:
**17.07.2013   Bulletin 2013/29**

(73) Titulaires:
• **Commissariat à l'Énergie Atomique et aux Énergies Alternatives**
**75015 Paris (FR)**
• **Institut Polytechnique de Grenoble**
**38031 Grenoble Cedex 1 (FR)**

(72) Inventeurs:
• **Perniola, Luca**
**38360 Noyarey (FR)**
• **Betti Beneventi, Giovanni**
**41040 Polinago (MO) (IT)**

(74) Mandataire: **Talbot, Alexandre et al**
**Cabinet Hecké**
**Europole, BP 1537**
**10, rue d'Arménie**
**38025 Grenoble Cedex 1 (FR)**

(56) Documents cités:
**EP-A2- 1 816 682     US-A1- 2011 155 984**

EP 2 615 612 B1

## Description

### Domaine technique de l'invention

L'invention est relative à une cellule mémoire comportant une zone mémoire formée dans un motif en matériau à changement de phase à base de chalcogénure et une jonction électrique de type p/n connectées en série entre des électrodes.

### État de la technique

Les mémoires à changement de phase comprennent un matériau à changement de phase, typiquement un chalcogénure par exemple un chalcogénure de formule $Ge_2Sb_2Te_5$ qui est disposé entre deux électrodes. Ce matériau à changement de phase peut basculer réversiblement entre un état amorphe résistif et un état cristallin conducteur. Ces deux états présentent des propriétés électriques différentes qui permettent de définir un état haut et un état bas de la cellule mémoire.

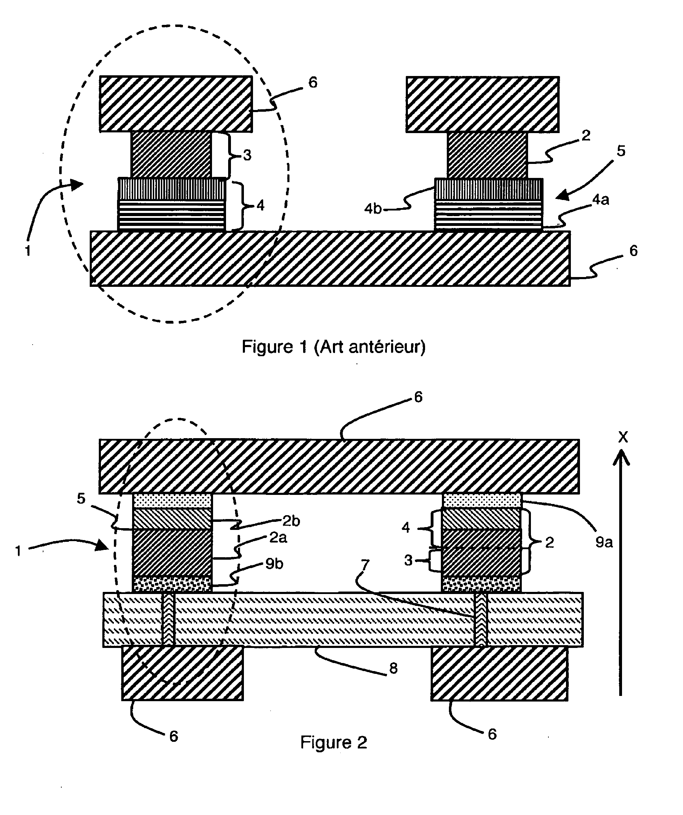

De manière conventionnelle, illustrée à la figure 1, la cellule mémoire 1 à changement de phase comporte un motif 2 en matériau à changement de phase qui forme la zone de mémoire 3 de la cellule 1. Cette zone de mémoire 3 est connectée en série avec une diode 4 de type p/n, c'est-à-dire en série avec une jonction 5 semi-conductrice de type p/n, entre deux électrodes 6. La cellule mémoire 1 est classiquement formée sur un substrat en silicium. La diode 4 est réalisée au moyen de deux films 4a et 4b en silicium qui sont dopés respectivement de type n et de type p. L'utilisation de la diode 4 permet d'éviter les erreurs lors de la lecture de l'information comprise dans la cellule mémoire en empêchant la lecture à partir d'un courant parasite provenant des cellules adjacentes.

La demande de brevet US 2011/155984 A1 décrit une cellule mémoire de ce type, comportant une jonction semi-conductrice de type p/n formée à l'interface entre deux matériaux dopés, l'un des deux matériaux pouvant subir un changement de phase.

Cependant, le mode de réalisation de la figure 1 est complexe et peu compact car il faut un premier niveau photolithographique spécifique pour former la diode de type p/n et un autre niveau photolithographique spécifique pour former et délimiter la zone de changement de phase. Ce second niveau photolithographique doit être positionné par rapport à la diode de type p/n et donc par rapport au niveau photolithographique précédent. Il apparaît donc que la réduction continue des dimensions dans les cellules mémoires augmente les contraintes lithographiques de ce type d'architectures mémoires car il faut réduire les dimensions tout en conservant des marges de sécurités suffisantes.

### Objet de l'invention

L'invention a pour objet une cellule mémoire à changement de phase qui soit facile à mettre en oeuvre, compacte et dont la mise en oeuvre est améliorée afin de faciliter son intégration à tous les stades d'élaboration des circuits intégrés.

On tend à atteindre cet objectif au moyen d'une cellule mémoire selon la revendication 1.

L'invention a également pour objet un procédé de dimensionnement d'une telle cellule mémoire afin de maitriser la température de la jonction lors de la phase de remise à zéro.

On tend à atteindre cet objectif au moyen d'un procédé selon la revendication 7.

### Description sommaire des dessins

D'autres avantages et caractéristiques ressortiront plus clairement de la description qui va suivre de modes particuliers de réalisation de l'invention donnés à titre d'exemples non limitatifs et représentés aux dessins annexés, dans lesquels :

- la figure 1 représente, de manière schématique, en coupe, une cellule mémoire selon l'art antérieur,
- la figure 2 représente, de manière schématique, en coupe, un premier mode de réalisation d'une cellule mémoire,
- la figure 3 représente, de manière schématique, en coupe, un second mode de réalisation d'une cellule mémoire,
- la figure 4 représente, de manière schématique, en coupe, une cellule mémoire en cours de fabrication sur un substrat.

### Description d'un mode de réalisation préférentiel de l'invention

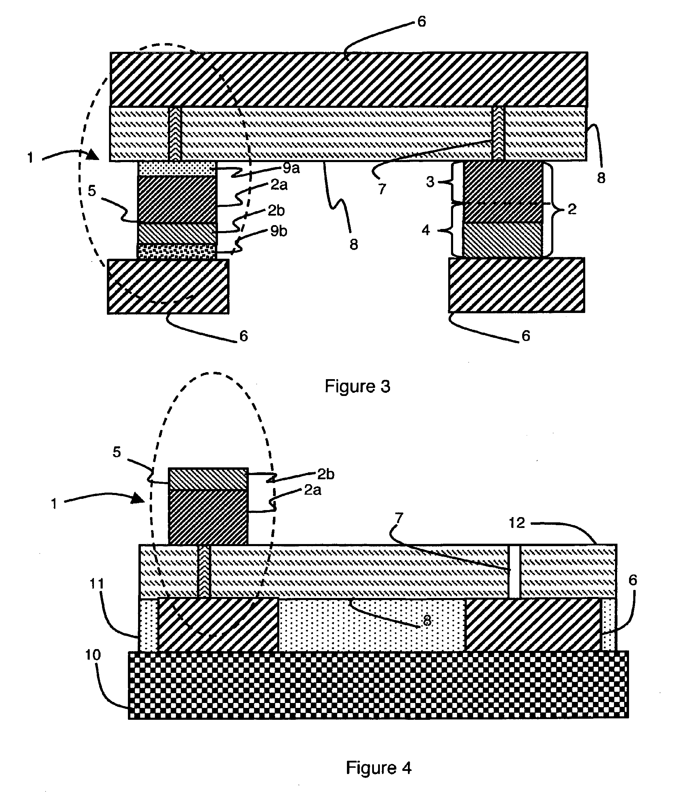

Comme illustré aux figures 2 et 3, la cellule mémoire 1 à changement de phase comporte une zone de mémoire 3 et une diode 4 munie d'une jonction 5 de type p/n disposées entre deux électrodes 6. La zone mémoire 3 est connectée en série avec la jonction 5 électrique de type p/n entre les deux électrodes 6.

La cellule mémoire comporte également un motif 2 réalisé dans un ou plusieurs matériaux à changement de phase qui est couplé à un élément chauffant 7. Le motif 2 en matériau à changement de phase et l'élément chauffant 7 sont connectés en série entre les deux électrodes 6.

Le motif 2 de la cellule mémoire est divisé en deux par la jonction 5. Un côté du motif 2 est d'un premier type de conductivité alors que l'autre côté du motif 2 est du type opposé de conductivité.

En d'autres termes, le motif 2 peut être décomposé en deux motifs adjacents dont l'interface définit la jonction 5.

Le premier motif 2a est réalisé dans un premier matériau à changement de phase d'un premier type de conductivité. Ce premier motif 2a forme une première zone de la diode 4. Le premier motif 2a a une première valeur de résistance thermique. La zone mémoire 3 est formée dans le premier motif 2a.

Le second motif 2b est réalisé dans un second matériau à changement de phase d'un second type de conductivité. Ce second motif 2b forme une seconde zone de la diode 4. Le second motif 2b a une seconde valeur de résistance thermique. Le premier motif 2a et le second motif 2b sont agencés pour former la jonction 5 électrique de type p/n les entre deux électrodes 6.

La jonction 5 est formée par la connexion de deux volumes en matériau à changement de phase qui sont et demeurent polycristallins durant le fonctionnement de la cellule mémoire 1.

Si le premier motif 2a possède une conduction de type p, le second motif 2b est de type n et inversement afin d'avoir la jonction électrique 5 recherchée. Le premier matériau à changement de phase peut être identique au deuxième matériau à changement en ce qui concerne ses constituants principaux mais ces deux matériaux doivent présenter des types de conductivité opposés.

L'interface entre les deux motifs 2a et 2b définit la position de la jonction. Les motifs 2a et/ou 2b peuvent présenter un dopage intrinsèque lié à la nature du matériau utilisé et/ou au procédé de dépôt employé. L'indication selon laquelle les motifs 2a et 2b sont dopés ne sous-entend pas qu'une étape de dopage est nécessaire après la formation du motif.

La zone mémoire 3 et la diode 4 sont formées toutes les deux dans un matériau à changement de phase ce qui autorise une plus grande liberté d'intégration car ces deux éléments peuvent être réalisés à basse température. A titre d'exemple, la température de dépôt du matériau à changement de phase est inférieure à la température de dépôt du silicium qui est classiquement utilisé pour former les diodes.

Lorsqu'un courant passe d'une des électrodes 6 à l'autre, il traverse le motif 2 en matériau à changement de phase en passant successivement par le premier motif 2a puis par le second motif 2b ou inversement. Le courant ne traverse le motif 2 que si le sens de passage est compatible avec le sens imposé par la diode 4.

L'élément chauffant 7 est couplé au premier motif 2a, l'élément chauffant 7 est séparé du second motif 2b par le premier motif 2a. L'élément chauffant 7 a une troisième valeur de résistance thermique. L'élément chauffant 7 est réalisé dans un matériau électriquement conducteur, par exemple un métal qui produit de la chaleur lorsqu'il est traverse par un courant. L'élément chauffant 7 est par exemple en tungstène.

De manière préférentielle, la zone mémoire 3 est formée dans le motif 2 au plus près de l'élément chauffant 7. De manière encore plus préférentielle, l'élément chauffant 7 a une interface avec le motif 2 en matériau à changement de phase. Dans ce cas, la zone mémoire 3 est disposée en contact avec l'élément chauffant 7. La température maximale atteinte par la cellule mémoire est localisée à l'interface entre l'élément chauffant 7 et le motif 2 ou entre l'élément chauffant 7 et le motif 2 si une couche d'accroche est utilisée.

Lors des phases de lecture, d'écriture et de remise à zéro de la cellule mémoire 1, le courant de porteurs de charge transite d'une première électrode 6 vers une seconde électrode 6 à travers successivement l'élément chauffant 7, le premier motif 2a et le second motif 2b. Le courant peut également transiter dans le sens inverse selon le type de la diode 4.

La température de fusion du matériau formant la zone mémoire 3 est, par exemple de l'ordre de 900K pour de nombreux matériaux à changement de phase ce qui définit l'intensité minimale du courant nécessaire pour obtenir une remise à zéro de la mémoire.

Lors de la phase d'écriture et de la phase de remise à zéro, le courant qui circule dans la cellule mémoire 1 modifie la phase cristalline de la zone mémoire 3.

Durant la phase d'écriture, la température à l'interface entre l'élément chauffant 7 et le premier motif 2a augmente jusqu'à atteindre et/ou dépasser la température de cristallisation du premier matériau à changement de phase. De cette manière, une partie du volume du premier motif 2a passe d'un état amorphe à un état polycristallin.

Durant la phase de remise à zéro, un courant plus important que précédemment est appliqué à l'intérieur de la cellule 1 et la température de l'interface entre le motif de chauffage 7 et le premier motif 2a augmente jusqu'à atteindre la fusion d'une partie du volume du premier motif 2a. Le volume fondu est ensuite refroidi rapidement pour figer la zone mémoire 3 dans un état amorphe.

De cette manière, le motif 2 en matériau à changement de phase comporte une zone mémoire 3 dont la résistivité évolue de façon réversible entre un état faiblement résistif et un état fortement résistif afin de définir des états « haut » et « bas » de la cellule mémoire 1. La zone mémoire 3 passe d'un état amorphe à un état cristallin selon les conditions appliquées. La zone de mémoire 3 est formée dans une des deux zones dopées du motif 2 en matériau à changement de phase. La cellule mémoire comporte pour cela un circuit d'application d'un courant d'écriture, d'un courant de remise à zéro et d'un courant de lecture qui transitent dans la zone mémoire 3 au moyen des deux électrodes 6.

Comme la cellule mémoire 1 est monobloc avec l'intégration de la diode 4 au plus près de la zone mémoire 3, il est important de maîtriser la température aux abords de la jonction 5 afin de réduire voire d'éliminer la diffusion des dopants à travers la jonction 5 lors des changements de phase. En maintenant la température de la jonction sous une température seuil, la diffusion des dopants est réduite ce qui permet de conserver, dans le temps, une diode 4 avec des bonnes performances électriques.

Dans un mode de réalisation préférentiel, il est possible de réduire les dimensions de la cellule mémoire 1 en formant le premier motif 2a dans un matériau à changement de phase qui nécessite une température de transformation plus faible que le matériau formant le second motif 2b ce qui permet de limiter la diffusion dans la jonction 5 ce qui a pour effet de limiter la diffusion dans la diode.

Comme le motif 2 est enrobé dans un matériau isolant électriquement et thermiquement, l'évacuation de chaleur est majoritairement réalisée à travers l'élément chauffant 7 et les électrodes 6. Afin de limiter l'évacuation de la chaleur dans la zone mémoire 3 de la cellule mémoire à travers la jonction électrique 5, il est préférable d'avoir une résistance thermique de l'élément chauffant 7 qui est la plus faible possible.

Il est également important d'avoir une bonne efficacité du chauffage de la zone mémoire par l'élément chauffant 7, une étendue raisonnable de la zone mémoire 3 et une bonne maitrise du courant traversant le motif 2 lors des phases d'écriture et de remise à zéro ce qui incite à avoir un élément chauffant présentant une faible surface de contact avec la zone mémoire 3.

Il a été découvert qu'une bonne évacuation de la chaleur dans le motif 2 peut être obtenue lorsque la résistance thermique de l'élément chauffant 7 est du même ordre de grandeur que la somme des résistances thermiques du premier 2a et du second 2b motifs. Le rapport entre la résistance thermique de l'élément chauffant 7 et la résistance thermique du motif 2 est compris entre 0,9 et 1,1. Cette configuration permet d'éloigner la jonction 5 des zones de haute température et donc d'assurer un fonctionnement stable dans le temps.

De manière préférentielle, la résistance thermique de l'élément chauffant 7 est égale à la somme des résistances thermiques du premier 2a et du second 2b motifs, c'est-à-dire égale à la résistance thermique du motif 2. Dans cette configuration, la température maximale dans la cellule mémoire est localisée à l'interface entre l'élément chauffant 7 et le premier motif 2a ce qui permet de chauffer une partie du premier motif 2a qui sert de zone mémoire 3 sans trop chauffer le reste du motif 2 formant la diode 4.

Afin d'avoir l'adéquation recherchée dans les résistances thermiques, il est possible de moduler les matériaux entrant en jeu et/ou de moduler les dimensions géométriques des différents motifs afin de tendre vers une cellule mémoire compacte et fiable.

De manière avantageuse, la surface de contact entre l'élément chauffant 7 et le motif 2 correspond à la surface de l'extrémité de l'élément chauffant 7 de sorte que l'élément chauffant 7 présente une section inférieure à la section du motif 2 afin de faciliter le procédé de réalisation général de la cellule mémoire. Dans cette architecture, la zone mémoire a une forme hémisphérique.

La figure 4 illustre une cellule mémoire en cours de réalisation selon le mode de réalisation de la figure 2. Des premières électrodes 6 sont formées sur le substrat 10 à l'intérieur d'un matériau électriquement isolant 11 pour former plusieurs cellules mémoires (ici deux cellules mémoires). Un second film électriquement isolant 12 est déposé sur une électrode 6 et un trou est formé dans le film électriquement isolant pour atteindre l'électrode 6 comme cela est représenté sur la partie droite de la figure 4. Le trou est ensuite rempli par un matériau électriquement conducteur pour former l'élément chauffant 7. Ensuite, le motif 2 en matériau à changement de phase peut être déposé sur l'élément chauffant 7 comme cela est représenté dans la partie gauche de la figure 4.

L'ordre des étapes peut être modifié afin de former le motif 2 sur une électrode puis former l'élément chauffant 7.

Afin de réaliser un élément chauffant 7 qui présente en plus une résistance mécanique minimale, le rapport de la hauteur sur la largeur ou sur le diamètre de l'élément chauffant ne dépasse pas une valeur seuil maximale. A titre d'exemple, pour un noeud technologique donné, le diamètre ou la largeur minimale de l'élément chauffant 7 est fixé par les performances de l'étape de photolithographie et de l'étape de gravure associée. Ces considérations technologiques peuvent définir la taille minimale de la cellule mémoire. A titre d'exemple, un rapport de la hauteur sur la largeur ou sur le diamètre qui est inférieur ou égal à 5 donne de bons résultats. La largeur ou le diamètre est défini dans une direction parallèle à la surface du substrat alors que la hauteur est définie perpendiculaire à cette surface.

Dans un mode de réalisation particulier, l'un des deux motifs 2a et 2b de la diode est formé par une étape additionnelle de dopage, par exemple par implantation. De manière préférentielle, le motif 2 est formé en une seule étape de dépôt avec un premier type de conductivité. La différenciation entre les motifs 2a et 2b est réalisée par dopage d'une partie du motif 2 pour former la diode 4. Dans ce mode de réalisation particulier, l'épaisseur totale du motif 2 est choisie de manière à permettre la formation de la diode 4 dans le motif 2 par implantation. A titre d'exemple, un motif 2 ayant une épaisseur supérieure ou égale à 50nm permet de former la diode 4 par implantation.

Afin de faciliter le dimensionnement, cette architecture tridimensionnelle peut être simulée dans une seule dimension si l'on considère que le maximum de la chaleur reçue dans la jonction 5 provient de la distance la plus courte par rapport à la zone de contact entre le motif 2 et l'élément chauffant 7. De cette manière, la condition sur les résistances thermiques énoncées plus haut peut être transformée en une condition sur les épaisseurs des différents éléments de cellule mémoire en considérant que la résistance thermique d'un matériau correspond à son épaisseur multipliée par sa résistivité thermique. Il est alors possible de définir l'épaisseur de l'élément chauffant 7, l'épaisseur du motif 2 et/ou des motifs 2a et 2b en fonction des contraintes technologiques qui pèsent sur les autres éléments de la cellule mémoire. Cette équation peut être écrite de la manière suivante :

$$0,9 \leq \frac{T^{2a} \cdot \rho_{th}^{2a} + T^{2b} \cdot \rho_{th}^{2b}}{T^{7} \cdot \rho_{th}^{7}} \leq 1,1$$

avec

$T^{2a}$ est l'épaisseur du premier motif (2a)

$T^{2b}$ est l'épaisseur du deuxième motif (2b)

$\rho_{th}^{2a}$ est la conductivité thermique du matériau formant le premier motif (2a)

$\rho_{th}^{2b}$ est la conductivité thermique du matériau formant le deuxième motif (2a)

$T^{7}$ est l'épaisseur de l'élément chauffant (7)

$\rho_{th}^{7}$ est la conductivité thermique de l'élément chauffant (7)

Au moyen d'une cellule mémoire répondant à la condition énoncée plus haut sur les résistances thermiques, la température au niveau de la jonction 5 est nettement plus basse que celle de la zone mémoire 3 ce qui permet de limiter la diffusion des dopants et d'éviter les risques de transformation des matériaux formant la diode 4. Cette configuration permet d'obtenir une différence de température minimale à l'intérieur de la diode de l'ordre de 85°C ce qui améliore la tenue dans le temps de la cellule mémoire.

Les matériaux à changement de phase sont, préférentiellement des matériaux à base de chalcogénure. Cependant, le matériau à changement de phase est en tout matériau qui peut changer de phase réversiblement au moyen d'un courant passant entre les deux électrodes 6, par exemple entre un état cristallin et un état amorphe, tel que par exemple GeSb. Un matériau à changement de phase est un matériau pouvant réaliser son changement de phase dans une durée compatible avec le temps d'écriture d'une cellule mémoire, c'est-à-dire que la durée de changement de phase est inférieure à 100 microsecondes. De ce fait, le matériau à changement de phase ne peut pas être n'importe quel type de matériau.

Le matériau chalcogénure est, par exemple, de type GeSbTe, GeTe, InGeTe, GeTeN, GeTeC, InSbTe de préférence dans un matériau à base de Ge et de Te ou au moins à base de Te ou à base de Sb. Selon les spécifications recherchées pour la cellule mémoire, les matériaux préférés pourront varier. Pour les applications où une vitesse élevée de fonctionnement est recherchée, le matériau à changement de phase est avantageusement choisi parmi GeTe, GeSb, SbTe. Si l'on cherche à travailler avec des températures élevées, le matériau à changement de phase est avantageusement choisi parmi GeTe, InGeTe, GeTeN, GeTeC. Si l'on souhaite travailler avec un courant de remise à zéro faible, le matériau est avantageusement de type GeSbTe dopé à l'azote ou au carbone.

Selon le mode d'élaboration utilisé, le matériau à changement de phase est considéré, initialement, comme de type n ou de type p bien qu'aucun dopant ne soit ajouté lors de son élaboration. Le matériau à changement de phase est formé, par exemple, par dépôt chimique en phase vapeur ou dépôt physique en vapeur. Le type de conductivité apparent observé provient du procédé de dépôt utilisé. Le type de conductivité peut également provenir de l'apport d'un dopant.

Le premier motif 2a et le second motif 2b en matériaux à changement de phase peuvent être formés par une unique couche en matériau à changement de phase qui présente deux types de conductivité opposés. Le premier motif 2a et le second motif 2b peuvent être également formés par des matériaux différents. Il est également envisageable d'utiliser une pluralité de couches élémentaires en matériaux à changement de phase qui ont des compositions différentes pour former le premier et/ou le second motifs en matériau à changement de phase.

Dans un mode de mise en oeuvre particulier, un matériau à changement de phase est déposé pour former le premier motif 2a et le second motif 2b. Le matériau à changement de phase est déposé avec un premier type de conductivité puis il est ensuite volontairement dopé par apport d'impuretés dopantes afin de former le second motif 2b d'un second type de conductivité opposé au premier type, c'est-à-dire opposé à celui dopage provenant de la formation du motif 2. Ce mode de réalisation est particulièrement intéressant car il permet de former simplement les deux motifs en matériau à changement de phase en réduisant le budget thermique et les risques d'incompatibilité physico-chimique.

Le second motif 2b d'un second type de conductivité peut être formé par implantation ionique. A titre d'exemple, la technique d'implantation à très basse énergie, à fort courant ionique et sous ultravide (UHV) peut être utilisée. Cette implantation ionique a pour effet de changer le type de dopage dans le second motif 2b. Cette zone de dopage d'un second type de conductivité peut également être formée par apport de l'impureté dopante lors du dépôt du matériau à changement de phase.

Il est également envisageable de former le motif 2 en matériau à changement de phase avec au moins deux matériaux à changement de phase différents qui présentent entre eux des types de conductivité opposés. Ainsi, le premier matériau déposé est de type p et le second matériau déposé est de type n ou inversement. Dans ce cas de figure, il n'y pas de matériau dopant qui est utilisé volontairement dans les deux matériaux à changement de phase du motif 2. A titre d'exemple, un matériau à changement de phase de type n est décrit par Reinhard et al. (« Properties of chalcogenide glass-silicon heterojunctions », Appl. Phys. Lett., Vol. 23, No. 4, 1973). Les autres matériaux à changement de phase cités dans la demande sont considérés dopés de type p. La première zone 2a est donc formée dans un premier matériau à changement de phase alors que la seconde zone 2b est formée dans un second matériau à changement de phase.

Dans une autre variante de réalisation, les zones dopées p et n du motif en matériau à changement de phase sont formées toutes les deux par implantation ionique dans le motif initial.

Il est également important que les première et/ou seconde zones 2a et 2b soient suffisamment épaisses pour que la zone de charge d'espace supporte le champ électrique imposée dans la portion qui travail en polarisation inverse, cette caractéristique dépend notamment de la tension de built-in, de la permittivité diélectrique des matériaux utilisés et des concentrations en dopants.

La cellule mémoire est, de préférence, de type pilier avec le premier motif 2a, le second motif 2b et l'élément chauffant 7 disposés au-dessus du substrat de support ce qui limite l'évacuation de la chaleur par conduction dans le substrat. Dans une structure de type pilier, les faces latérales du motif 2 sont découvertes ou elles sont recouvertes par un matériau électriquement isolant, par exemple un oxyde de silicium ou un nitrure de silicium. Cette architecture impose le passage du courant dans un sens particulier entre les deux électrodes.

Le matériau à changement de phase qui est dopé doit avoir un dopage suffisant pour présenter un comportement redresseur du courant satisfaisant, typiquement supérieur à 1000. Le dopage est réalisé par des impuretés dopantes dont la concentration est comprise entre $10^{14}$-$10^{17}$ atomes/cm$^3$. Le dopage du motif 2 pour former la jonction p/n peut être réalisé par un dépôt chimique en phase vapeur ou par une implantation ionique. Le dopage du motif 2 peut être réalisé, par exemple, par des atomes d'oxygène, de zinc ou de gallium.

Le motif 2 en matériau à changement de phase présente deux faces principales qui sont connectées directement ou indirectement aux électrodes 6. La connexion entre une des électrodes 6 et le matériau à changement de phase est réalisée par l'élément chauffant 7.

Cet élément chauffant 7 est en matériau électriquement conducteur qui produit de la chaleur lorsqu'il est traversé par un courant. L'élément chauffant 7 est en contact électrique avec le matériau à changement de phase, il est avantageusement compatible avec ce dernier d'un point de vue physico-chimique. Le matériau constituant l'élément chauffant 7 est choisi parmi les matériaux ayant un point de fusion supérieur à celui du matériau à changement de phase. Le matériau formant l'élément chauffant 7 est choisi de manière à maximiser le chauffage par effet joule dans le matériau à changement de phase adjacent. Avantageusement, l'élément chauffant 7 permet de chauffer la plus grande partie possible du matériau à changement de phase qui sert de zone mémoire 3. L'élément chauffant 7 est, par exemple, en TiN, TiSiN, W. La forme de l'élément chauffant 7 est choisie en fonction de la forme de la cellule mémoire 1 (de la zone de mémoire 3) de manière à maximiser le chauffage par effet joule lors du passage d'un courant dans la cellule mémoire 1. La forme de l'élément chauffant 7 est, par exemple, allongée selon la direction de transit du courant. L'élément chauffant 7 peut également être formé par une couche homogène qui réalise l'interface entre l'électrode 6 et le motif 2 en matériau à changement de phase. L'élément chauffant 7 apportant de la chaleur au matériau à changement de phase, il ne doit pas être disposé à proximité de la diode 4 afin d'éviter la migration des dopants liée à une température trop élevée. L'élément chauffant 7 et la diode 4 sont donc disposés de part et d'autre de la zone mémoire 3. Ainsi, l'élément chauffant 7 apporte des calories à la zone mémoire 3 et non pas à la diode 4. Au moyen d'un logiciel de simulation capable de résoudre les équations aux dérivées partielles tel que Sentaurus, Comsol Multiphysics, Abacus ou Matlab, il est possible de définir la forme de l'élément chauffant 7, la taille de la zone mémoire 3, la distance entre la diode 4 et l'élément chauffant 7, le courant nécessaire à l'obtention du changement de phase et les matériaux à utiliser. Le logiciel Sentaurus est avantageusement utilisé car il comporte un module spécifique pour les architectures à changement de phase. Pour une cellule mémoire de surface $4F^2$ intégrée dans une technologie semi-conducteur de type 90nm, la cellule occupe une surface d'environ $10^{-2}$ micromètres carrés sur une hauteur de l'ordre de 300nm, la diode étant comprise dans la cellule.

Les électrodes 6 qui permettent de sélectionner la cellule mémoire 1 sont en matériau électriquement conducteur. Ces électrodes 6 permettent d'apporter la quantité de courant nécessaire au changement d'état de la zone de mémoire (écriture) et à la lecture de son état.

De manière préférentielle, les électrodes 6 sont dans des matériaux qui présentent une faible résistivité, par exemple, en matériau métallique ou en matériau semi-conducteur fortement dopé pour présenter un comportement électrique proche de celui d'un métal. Encore plus avantageusement, les électrodes 6 sont formées avec un budget thermique réduit (typiquement inférieur à 400°C), les électrodes 6 sont alors en matériau métallique, par exemple en tungstène.

De manière préférentielle, dans une matrice de cellules mémoires 1, les cellules 1 sont dans une organisation en rangées et en colonnes et une des électrodes 6 connecte toutes les cellules 1 d'une même rangée de la matrice tandis que l'autre électrode 6 connecte toutes les cellules 1 d'une même colonne de la matrice (organisation « crossbar »).

De manière préférentielle, une couche d'isolation 8 est disposée entre le motif 2 en matériau à changement de phase et une des électrodes 6. La couche d'isolation 8 sépare le motif 2 en matériau à changement de phase et l'électrode 6. L'élément chauffant 7 traverse la couche d'isolation 8 afin de réaliser la connexion électrique entre l'électrode 6 et le motif 2 en matériau à changement de phase. La couche d'isolation 8 est réalisée avec un matériau isolant qui présente une faible conductivité thermique. La couche d'isolation 8 peut être réalisée par un matériau diélectrique, par exemple, un oxyde de silicium, un nitrure de silicium ou un mélange ou un empilement de ces derniers. Dans un mode de réalisation particulier, le matériau 12 est conservé pour former la couche d'isolation 8.

De manière préférentielle, une zone passive 9 peut également être disposée entre le motif 2 en matériau à changement de phase et au moins une des électrodes 6. Cette zone passive 9 est alors formée sur la face principale du motif 2 en matériau à changement de phase, c'est-à-dire directement en contact avec la partie du motif 2 formant la zone mémoire 3 et/ou directement en contact avec la partie du motif formant la diode 3. La zone passive 9 doit présenter une température de fusion supérieure à celle du matériau à changement de phase. Si deux zones passives 9 sont formées de part et d'autre du motif 2 en matériau à changement de phase, ces deux zones 9 peuvent être dans le même matériau ou dans des matériaux différents 9a, 9b. Les zones passives 9 pouvant être disposées entre l'élément chauffant 7 et la zone mémoire 3, elles ne doivent pas empêcher le chauffage par effet Joule de la zone mémoire 3 depuis l'élément chauffant 7. La zone passive 9 est formée dans un matériau électriquement conducteur, par exemple en Ti, TiN ou TaN. La zone passive peut également servir à limiter ou éliminer la diffusion du matériau à changement de phase avec l'électrode 6 ou l'élément chauffant 7. La figure 3 illustre deux modes de réalisation différents de la même architecture de cellule mémoire. La cellule de la partie gauche comporte des zones passives 9a et 9b alors que la cellule de la partie droite en est dépourvue. Afin de faciliter le procédé de fabrication, il est préférable d'intégrer un seul type de cellule mémoire dans une matrice de cellules. La zone passive 9 peut faciliter l'accroche du motif 2 sur l'électrode 6 et/ou sur l'élément chauffant 7

L'obtention d'un matériau chalcogénure dopé dépend des caractéristiques du procédé de réalisation et non obligatoirement de l'ajout d'un gaz dopant. La caractérisation du matériau obtenu afin de déterminer son type de conductivité peut être réalisée, par exemple, par des mesures à effet Hall, par des mesures thermoélectriques exploitant l'effet Seebeck, par une mesure dite « à redressement » ou au moyen de techniques optiques qui utilisent le « photovoltage » de surface. La concentration équivalente en dopants peut être déterminée au moyen de mesures de capacités électrique en fonction de la tension. Le mode opératoire utilisé pour déterminer cette caractéristique est décrit dans le document de Dieter K. Schroeder, Semiconductor Material Device Characterization, Wiley-Interscience ; 2 edition (June 17, 1998).

La concentration de dopants à ajouter pour former la seconde zone dopée est déterminée en fonction des résultats obtenus concernant le type de conductivité et la concentration équivalente en dopants à partir des mesures précédentes.

La concentration de dopants qui est ajoutée pour former la seconde zone dopée doit être suffisante pour permettre un bon effet redresseur de la diode, mais elle ne doit pas favoriser la formation d'une jonction tunnel ohmique entre les première et seconde zones.

En plus d'être particulièrement compact, ce dispositif est compatible avec une intégration dans les niveaux d'interconnexion métallique car toutes les étapes technologiques utilisées et en particulier les étapes de dépôt sont possibles à des températures inférieures à 450°C voire inférieures à 400°C. De cette manière, la cellule mémoire peut être formée selon les contraintes définies par le Back-End of Line (BEOL) qui régit l'intégration des niveaux d'interconnexion des circuits intégrés.

Dans un mode de réalisation particulier, la cellule mémoire 1 est réalisée au-dessus d'un substrat semi-conducteur, par exemple en silicium, qui comporte un ou plusieurs dispositif actifs. Dans ce cas particulier, la cellule mémoire 1 à changement de phase est formée au-dessus du niveau comportant les dispositifs actifs, par exemple dans un matériau électriquement isolant. Ce mode de réalisation impose un budget thermique maximal ne pouvant pas être dépassé pour assurer le fonctionnement des dispositifs actifs. La diode 4 est formée au dessus du niveau comportant les dispositifs actifs comme les transistors ce qui permet de conserver une compacité élevée en libérant de la surface sur le substrat.

Dans un premier mode de réalisation, illustré à la figure 2, la première zone 2a est formée sous la seconde zone 2b. Des zones passives 9a, 9b sont avantageusement disposées sur les faces principales du motif 2 en matériau à changement de phase. Un élément chauffant 7 réalise la connexion électrique entre une des électrodes 6 (l'électrode inférieure) et la première zone 2a. L'élément chauffant 7 est disposé à proximité de la zone mémoire 3 afin de maximiser le chauffage par effet joule. L'élément chauffant 7 traverse la couche d'isolation 8 qui est localisée entre l'électrode 6 inférieure et la zone passive 9b en contact avec la première zone 2a. L'électrode 6 supérieure est en contact avec la zone passive 9a associée à la seconde zone 2b. Dans ce mode de réalisation, la première zone 2a est réalisée au moyen du dopage non intentionnel du matériau à changement de phase. La zone mémoire 3 est donc formée dans une zone dopée non intentionnellement, c'est-à-dire dans la zone la plus faiblement dopée du motif 2.

Dans un deuxième mode de réalisation, illustré à la figure 3, la première zone 2a est formée au-dessus de la seconde zone 2b. Des zones passives 9a, 9b sont avantageusement disposées sur les faces principales du motif 2 en matériau à changement de phase. Un élément chauffant 7 réalise la connexion électrique entre une des électrodes 6 (l'électrode supérieure) et la première zone 2a. L'élément chauffant 7 est disposé à proximité de la zone mémoire 3 afin de maximiser le chauffage par effet joule. L'élément chauffant 7 traverse la couche d'isolation 8 qui est localisée entre l'électrode 6 supérieure et la zone passive 9a en contact avec la première zone 2a. L'électrode 6 supérieure est en contact avec la zone passive 9b associée à la seconde zone 2b. Dans ce mode de réalisation, la première zone 2a est réalisée au moyen du dopage non intentionnel du matériau à changement de phase. La zone mémoire 3 est donc formée dans une zone dopée non intentionnellement, c'est-à-dire dans la zone la plus faiblement dopée du motif 2.

Dans un troisième mode de réalisation non représenté, la première zone 2a est réalisée au moyen du dopage intentionnel du matériau à changement de phase. La zone mémoire 3 est donc formée dans la zone dopée intentionnellement, c'est-à-dire la zone la plus fortement dopée du motif 2.

Le motif 2 en matériau à changement de phase peut être formé à l'intérieur d'un matériau électriquement isolant, par exemple de l'air ou un autre gaz ou un autre matériau isolant. Dans ces conditions, il est nécessaire de prendre en compte la conduction de la chaleur dans ce matériau pour définir les dimensions des différents éléments de la cellule mémoire. Il est également envisageable d'utiliser une structure à cavité d'air partielle (les figures 2 à 4) ou complète.

Dans un mode de mise en oeuvre particulier, un matériau de couverture est déposé puis gravé pour former un trou. Le fond du trou débouche directement ou indirectement sur l'électrode 6 inférieure. Selon les modes de réalisation, l'élément chauffant 7 peut être présent ou non dans le fond du trou. Le matériau à changement de phase est déposé afin de remplir le trou et former le motif 2 en matériau à changement de phase. Le matériau à changement de phase est dopé d'un premier type de conductivité.

Une étape de dopage est réalisée au moyen d'une des techniques déjà citées ci-dessus pour obtenir la formation d'un volume de matériau dopé du type opposé et former ainsi la jonction 5.

L'élément chauffant 7 et/ou l'électrode 6 supérieure sont ensuite formées afin de réaliser une cellule mémoire selon un des modes de réalisation illustré aux figures 2 et 3.

Ce mode de réalisation présente l'avantage d'utiliser un faible nombre d'étapes technologiques et de pouvoir être intégré avec un budget thermique limité.

Dans une variante de réalisation, un second matériau est déposé afin de compléter le motif 2 et ainsi former la diode 4 et la zone mémoire 3.

Dans un mode de mise en oeuvre particulier de la cellule mémoire, des contraintes technologiques font que certaines dimensions de la cellule mémoire sont imposées, par exemple l'épaisseur de la cellule mémoire est définie, mais il est également envisageable que l'épaisseur du premier motif, du second motif ou de l'élément chauffant 7 soit définie.

Afin d'obtenir une cellule mémoire extrêmement compacte, il est intéressant de définir les dimensions des différents éléments de la cellule mémoire en fonction de la densité d'intégration recherchée afin d'intégrer au plus près la jonction 5 et la zone mémoire 3 sans remettre en question la fiabilité de la cellule mémoire.

Le motif 2 en matériau à changement de phase et l'élément chauffant 7 sont dimensionnés de manière à présenter des résistances thermiques égales ou du même ordre de grandeur selon l'axe X ce qui permet de s'affranchir de la section de la mémoire pour assimiler la cellule mémoire à un dispositif unidimensionnel. L'axe X représente sensiblement le sens de transit du courant dans la cellule entre les deux électrodes 6.

Ainsi, en plaçant le motif 2 en contact avec l'élément chauffant 7, la zone mémoire 3 est disposée en contact avec l'élément chauffant 7 et son étendue à l'intérieur du motif 2 est maitrisée.

Dans le cas particulier où l'une des deux zones dopées de la diode 4 est formée par dopage, l'épaisseur minimale du motif 2 est imposée par des contraintes technologiques, par exemple liées aux conditions d'implantation ou à la diffusion des dopants à l'intérieur du motif 2.

Si les dimensions de l'élément chauffant 7 sont également définies par des contraintes technologiques liées au procédé de réalisation et/ou à la compacité de la structure, les dimensions de l'élément chauffant 7 et du motif 2 sont définies.

Dans une telle structure, il est alors possible de connaître la température au niveau de la jonction 5 en fonction de la température présente aux bornes de la cellule et de la valeur de courant appliqué ce qui permet d'affiner le dimensionnement de la structure.

D'après le principe de thermo-équivalence, la différence de température entre la zone mémoire 3 et la jonction 5 peut être exprimée en fonction du courant circulant dans la cellule 1 et des résistances thermique et électrique du premier motif 2a de la manière suivante :

$$(1) \quad T_R - T_J = R_{el}^{2a} \cdot R_{th}^{2a} \cdot I_R \cdot I_R \quad ,$$

avec

$T_R$ la température de l'interface entre l'élément chauffant 7 et le premier motif 2a en Kelvin;
$T_J$ la température de la jonction 5 en Kelvin;

$R_{el}^{2a}$ la résistance électrique du premier motif 2a en Ohm dans la région polycristalline;

$R_{th}^{2a}$ la résistance thermique du premier motif 2a en Kelvin/Watt ;

$I_R$ le courant circulant dans la mémoire 1 en Ampère.

Cette équation permet de relier les dimensions du premier motif 2a représentées par la résistance électrique du premier motif 2a, le courant circulant dans la cellule mémoire 1, la température de la jonction 5 et la température de l'interface entre l'élément chauffant 7 et le premier motif 2a.

De la même manière, l'équivalence électrothermique de la cellule 1 peut être écrite durant la remise à zéro :

$$(2) \quad T_R - T_O = R_{ON}^{S} \cdot R_{th}^{//} \cdot I_R \cdot I_R \quad ,$$

avec

$T_R$ la température de l'interface entre l'élément chauffant 7 et le premier motif 2a en Kelvin;
$T_O$ la température présente aux bornes de la cellule en Kelvin (la température ambiante de la cellule);

$R_{ON}^{S}$ la résistance électrique de la cellule, c'est-à-dire la somme de la résistance électrique de l'élément chauffant 7, du premier motif 2a et du second motif 2b en Ohm;

$R_{th}^{//}$ la résistance thermique équivalente du motif 2 et de l'élément chauffant 7 montés en parallèles en Kelvin/Watt ;

$I_R$ le courant circulant dans la mémoire en Ampère.

En combinant, les deux équations précédentes, il est alors possible d'exprimer la température de la jonction $T_J$ en fonction des conditions appliqués à la cellule et de ses caractéristiques électriques et thermiques de la manière suivante :

$$(3) \quad T_J = T_0 + R_{ON}^{S} \cdot R_{th}^{//} \cdot I_R \cdot I_R - R_{el}^{2a} \cdot R_{th}^{2a} \cdot I_R \cdot I_R$$

dans un mode de réalisation particulier qui convient bien à une cellule mémoire de type pilier, le courant de remise à zéro $I_R$ est égal à 1,5 fois le courant de fusion $I_M$ qui peut être écrit sous la forme

$$(4) \quad I_M = \sqrt{\frac{T_M - T_0}{R_{ON}^{S} - R_{th}^{//}}}$$

Ainsi, en imposant la température maximale que ne doit pas atteindre la jonction 5 afin de conserver un fonctionnement acceptable pour la durée de vie espérée, on impose également une condition sur les résistances thermiques et électriques de la cellule mémoire.

Lorsque cette contrainte technologique est associée à l'équivalence ou quasi-équivalence de la résistance thermique entre le motif 2 et l'élément chauffant 7 cela fixe les dimensions de la cellule mémoire et/ou le courant maximal acceptable par la cellule mémoire. Il est alors possible de moduler la température de la jonction en fonction du diamètre de l'élément chauffant 7 qui sert à définir l'état de la zone mémoire 3.

La résistance électrique des matériaux utilisés peut être mesurée par exemple par la technique des 4 pointes. La résistance thermique peut être mesurée pour sa part au moyen de la technique trois Oméga décrite, par exemple, dans la publication de D.G. Cahill et al. J. Appl. Phys., 93, 793, (2003).

En d'autres termes, la méthode de dimensionnement peut être résumée de la manière suivante :

- définir une première relation entre les dimensions du premier motif 2a, du second motif 2b et de l'élément chauffant 7 de manière à avoir un rapport de la résistance thermique de l'élément chauffant 7 sur la somme des résistances thermiques du premier motif 2a et du second motif 2b selon le premier axe compris entre 0,9 et 1,1,
- définir une seconde relation entre les dimensions du premier motif 2a, le courant circulant dans la cellule mémoire 1, la température de la jonction 5 et la température de l'interface entre l'élément chauffant 7 et le premier motif 7 d'après le principe d'équivalence électrothermique,
- définir une troisième relation entre les dimensions du premier motif 2, du deuxième motif 2, de l'élément chauffant 7, le courant circulant dans la cellule mémoire 1, la température aux bornes de la cellule mémoire 1 et la température de l'interface entre l'élément chauffant 7 et le premier motif 2a d'après le principe d'équivalence électrothermique,
- exprimer la température de la jonction 5 en fonction de la température aux bornes de la cellule mémoire 1, du courant circulant aux bornes de l'élément chauffant 7, des dimensions du premier motif 2a, du second motif 2b et de l'élément chauffant 7 à partir des première, deuxième et troisième relations.

Une fois les dimensions de la cellule 1 imposée en fonction des diverses contraintes technologique, comme par exemple la température maximale autorisée par la jonction 5, l'épaisseur minimale ou maximale du premier motif 2a, du deuxième motif 2b ou de l'élément chauffant 7, il ne reste plus qu'à former la cellule mémoire 1.

## Revendications

**1.** Cellule mémoire (1) comportant :

- un premier motif (2a) en un premier matériau à changement de phase d'un premier type de conductivité, le premier motif (2a) ayant une première valeur de résistance thermique,
- un second motif (2b) en un second matériau d'un second type de conductivité, le second motif (2b) ayant une seconde valeur de résistance thermique, le premier et le second motifs (2a, 2b) étant agencés pour former une jonction électrique (5) de type p/n entre deux électrodes (6), la jonction (5) étant située à l'interface entre les deux motifs (2a, 2b) dans une zone où leurs matériaux sont polycristallins,
- un élément chauffant (7) connecté au premier motif (2a), l'élément chauffant (7) étant séparé du second motif (2b) par le premier motif (2a), l'élément chauffant (7) ayant une troisième valeur de résistance thermique,
- une zone mémoire (3) par changement de phase formée en contact électrique avec l'élément chauffant (7) dans une partie du premier motif (2a),

cellule mémoire **caractérisée en ce que** le second matériau du second motif (2b) est en un matériau à changement de phase, et **en ce que** le rapport entre la résistance thermique de l'élément chauffant et la somme des résistances thermiques premier motif (2a) et du second motif (2b) est compris entre 0,9 et 1,1.

**2.** Cellule mémoire selon la revendication 1, **caractérisée en ce que** le premier motif (2a) et le second motif (2b) sont formés par le même matériau.

**3.** Cellule mémoire selon l'une des revendications 1 et 2, **caractérisée en ce qu'**elle comporte un circuit d'application d'un premier courant configuré pour fondre le premier matériau à changement de phase.

**4.** Cellule mémoire selon l'une quelconque des revendications 1 à 3, **caractérisée en ce qu'**elle comporte un circuit d'application d'un second courant configuré pour entrainer la cristallisation du premier matériau à changement de phase.

**5.** Cellule mémoire selon l'une quelconque des revendications 1 à 4, **caractérisée en ce que** le motif (2) en matériau à changement de phase est formé par des couches élémentaires en matériaux à changement de phase ayant des compositions différentes.

**6.** Cellule mémoire selon l'une quelconque des revendications 1 à 5, **caractérisée en ce que** les épaisseurs de l'élément chauffant (7), du premier motif en matériau à changement de phase (2a) et du deuxième motif du matériau à changement de phase (2b) sont configurées pour satisfaire l'équation:

$$0,9 \leq \frac{T^{2a} \cdot \rho_{th}^{2a} + T^{2b} \cdot \rho_{th}^{2b}}{T^{7} \cdot \rho_{th}^{7}} \leq 1,1$$

dans laquelle:

$T^{2a}$ est l'épaisseur du premier motif (2a)
$T^{2b}$ est l'épaisseur du deuxième motif (2b)

$\rho_{th}^{2a}$ est la conductivité thermique du matériau formant le premier motif (2a)

$\rho_{th}^{2b}$ est la conductivité thermique du matériau formant le deuxième motif (2a) $T^{7}$ est l'épaisseur de l'élément chauffant (7)

$\rho_{th}^{7}$ est la conductivité thermique de l'élément chauffant (7)

**7.** Procédé de dimensionnement d'une cellule mémoire (1) à changement de phase comportant successivement, selon un premier axe, un élément chauffant (7), un premier motif (2a) en premier matériau à changement de phase, un second motif (2b) en second matériau à changement de phase, les premier et second motifs formant une jonction p/n (5) dans unz zone où leurs matériaux sont polycristallins, une zone mémoire (3) par changement de phase en contact électrique avec l'élément chauffant (7) dans une partie du premier motif (2a), le procédé comportant :

- définir une première relation entre les dimensions du premier motif (2a), du second motif (2b) et de l'élément chauffant (7) de manière à avoir un rapport de la résistance thermique de l'élément chauffant (7) sur la somme des résistances thermiques du premier motif (2a) et du second motif (2b) selon le premier axe compris entre 0,9 et 1,1,
- définir une seconde relation entre les dimensions du premier motif (2a), le courant circulant dans la cellule mémoire (1), la température de la jonction (5) et la température de l'interface entre l'élément chauffant (7) et le premier motif (7) d'après le principe d'équivalence électrothermique,
- définir une troisième relation entre les dimensions du premier motif (2), du deuxième motif (2), de l'élément chauffant (7), le courant circulant dans la cellule mémoire (1), la température aux bornes de la cellule mémoire (1) et la température de l'interface entre l'élément chauffant (7) et le premier motif (2a) d'après le principe d'équivalence électrothermique,
- exprimer la température de la jonction (5) en fonction de la température aux bornes de la cellule mémoire (1), du courant circulant aux bornes de l'élément chauffant (7), des dimensions du premier motif (2a), du second motif (2b) et de l'élément chauffant (7) à partir des première, deuxième et troisième relations.

**8.** Procédé selon la revendication 7 **caractérisé en ce que** la première relation est:

$$0,9 \leq \frac{T^{2a} \cdot \rho_{th}^{2a} + T^{2b} \cdot \rho_{th}^{2b}}{T^{7} \cdot \rho_{th}^{7}} \leq 1,1$$

dans laquelle :

$T^{2a}$ est l'épaisseur du premier motif (2a)
$T^{2b}$ est l'épaisseur du deuxième motif (2b)

# EP 2 615 612 B1

$\rho_{th}^{2a}$ est la conductivité thermique du matériau formant le premier motif (2a)

$\rho_{th}^{2b}$ est la conductivité thermique du matériau formant le deuxième motif (2a) $T^7$ est l'épaisseur de l'élément chauffant (7)

$\rho_{th}^{7}$ * est la conductivité thermique de l'élément chauffant (7)

9. Procédé selon l'une des revendications 7 et 8 **caractérisé en ce que** la deuxième relation est:

$$T_R - T_J = R_{el}^{2a}.R_{th}^{2a}.I_R.I_R \qquad ,$$

avec $T_R$ la température de l'interface entre l'élément chauffant (7) et le premier motif (2a);

$T_J$ la température de la jonction électrique (5);

$R_{el}^{2a}$ la résistance électrique du premier motif (2a);

$R_{th}^{2a}$ la résistance thermique du premier motif (2a) ;

$I_R$ le courant circulant dans la cellule mémoire.

10. Procédé selon l'une quelconque des revendications 7 à 9 **caractérisé en ce que** la troisième relation est:

$$T_R - T_O = R_{ON}^{S}.R_{th}^{//}.I_R.I_R \ ,$$

avec

$T_R$ la température de l'interface entre l'élément chauffant (7) et le premier motif (2a);
$T_O$ la température présente aux bornes de la cellule;

$R_{ON}^{S}$ la résistance électrique de la cellule;

$R_{th}^{//}$ la résistance thermique équivalente de l'élément chauffant (7) monté en parallèles du premier motif (2a) et du deuxième motif (2b) montés en série;
$I_R$ le courant circulant dans la mémoire.

**Patentansprüche**

1. Speicherzelle (1), umfassend:

- ein erstes Muster (2a) aus einem ersten Phasenwechselmaterial von einem ersten Leitfähigkeitstyp, wobei das erste Muster (2a) einen ersten Wärmewiderstandswert hat,
- ein zweites Muster (2b) aus einem zweiten Material von einem zweiten Leitfähigkeitstyp, wobei das zweite Muster (2b) einen zweiten Wärmewiderstandswert hat, wobei das erste und das zweite Muster (2a, 2b) dazu ausgelegt sind, einen elektrischen Übergang (5) vom Typ p-n zwischen zwei Elektroden (6) zu bilden, wobei der Übergang (5) an der Grenzfläche zwischen den beiden Mustern (2a, 2b) in einem Bereich gelegen ist, in dem deren Materialien polykristallin sind,
- ein mit dem ersten Muster (2a) verbundenes Heizelement (7), wobei das Heizelement (7) durch das erste Muster (2a) von dem zweiten Muster (2b) getrennt ist, wobei das Heizelement (7) einen dritten Wärmewiderstandswert hat,
- einen Speicherbereich (3) durch Phasenwechsel, der in elektrischem Kontakt mit dem Heizelement (7) in einem Teil des ersten Musters (2a) ausgebildet ist,

Speicherzelle, **dadurch gekennzeichnet, dass** das zweite Material des zweiten Musters (2b) aus einem Phasenwechselmaterial besteht und dass das Verhältnis zwischen dem Wärmewiderstand des Heizelements und der Summe aus den Wärmewiderständen des ersten Musters (2a) und des zweiten Musters (2b) zwischen 0,9 und 1,1 beträgt.

2. Speicherzelle nach Anspruch 1, **dadurch gekennzeichnet, dass** das erste Muster (2a) und das zweite Muster (2b) von dem gleichen Material gebildet sind.

3. Speicherzelle nach einem der Ansprüche 1 und 2, **dadurch gekennzeichnet, dass** sie einen Schaltkreis zum Anlegen eines ersten Stroms umfasst, der dazu ausgelegt ist, das erste Phasenwechselmaterial zu schmelzen.

4. Speicherzelle nach einem der Ansprüche 1 bis 3, **dadurch gekennzeichnet, dass** sie einen Schaltkreis zum Anlegen eines zweiten Stroms umfasst, der dazu ausgelegt ist, die Kristallisation des ersten Phasenwechselmaterials zu bewirken.

5. Speicherzelle nach einem der Ansprüche 1 bis 4, **dadurch gekennzeichnet, dass** das Muster (2) aus Phasenwechselmaterial durch einzelne Schichten aus Phasenwechselmaterialien mit unterschiedlichen Zusammensetzungen gebildet ist.

6. Speicherzelle nach einem der Ansprüche 1 bis 5, **dadurch gekennzeichnet, dass** die Dicken des Heizelements (7), des ersten Musters aus Phasenwechselmaterial (2a) und des zweiten Musters aus dem Phasenwechselmaterial (2b) dazu ausgelegt sind, die Gleichung zu erfüllen:

$$0,9 \leq \frac{T^{2a} \cdot \rho_{th}^{2a} + T^{2b} \cdot \rho_{th}^{2b}}{T^{7} \cdot \rho_{th}^{7}} \leq 1,1$$

worin:

$T^{2a}$ die Dicke des ersten Musters (2a) ist

$T^{2b}$ die Dicke des zweiten Musters (2b) ist

$\rho_{th}^{2a}$ die Wärmeleitfähigkeit des das erste Muster (2a) bildenden Materials ist

$\rho_{th}^{2\beta}$ die Wärmeleitfähigkeit des das zweite Muster (2a) bildenden Materials ist

$T^{7}$ die Dicke des Heizelements (7) ist

$\rho_{th}^{7}$ die Wärmeleitfähigkeit des Heizelements (7) ist.

7. Verfahren zur Dimensionierung einer Phasenwechsel-Speicherzelle (1), die nacheinander, entlang einer ersten Achse, ein Heizelement (7), ein erstes Muster (2a) aus erstem Phasenwechselmaterial, ein zweites Muster (2b) aus zweitem Phasenwechselmaterial, wobei das erste und das zweite Muster in einem Bereich, in dem ihre Materialien polykristallin sind, einen p-n-Übergang (5) bilden, einen Speicherbereich (3) durch Phasenwechsel in elektrischem Kontakt mit dem Heizelement (7) in einem Teil des ersten Musters (2a) umfasst, wobei das Verfahren umfasst:

- Definieren einer ersten Beziehung zwischen den Abmessungen des ersten Musters (2a), des zweiten Musters (2b) und des Heizelements (7), um ein Verhältnis des Wärmewiderstandes des Heizelements (7) zu der Summe aus den Wärmewiderständen des ersten Musters (2a) und des zweiten Musters (2b) entlang der ersten Achse zwischen 0,9 und 1,1 zu haben,
- Definieren einer zweiten Beziehung zwischen den Abmessungen des ersten Musters (2a), dem in der Speicherzelle (1) fließenden Strom, der Temperatur des Übergangs (5) und der Temperatur der Grenzfläche zwischen dem Heizelement (7) und dem ersten Muster (7) nach dem elektrothermischen Äquivalenz-Prinzip,
- Definieren einer dritten Beziehung zwischen den Abmessungen des ersten Musters (2), des zweiten Musters (2), des Heizelements (7), dem in der Speicherzelle (1) fließenden Strom, der Temperatur an den Anschlüssen der Speicherzelle (1) und der Temperatur der Grenzfläche zwischen dem Heizelement (7) und dem ersten Muster (2a) nach dem elektrothermischen Äquivalenz-Prinzip,
- Ausdrücken der Temperatur des Übergangs (5) in Abhängigkeit von der Temperatur an den Anschlüssen der Speicherzelle (1), des an den Anschlüssen des Heizelements (7) fließenden Stroms, der Abmessungen des ersten Musters (2a), des zweiten Musters (2b) und des Heizelements (7) anhand der ersten, der zweiten und der dritten Beziehung.

8. Verfahren nach Anspruch 7, **dadurch gekennzeichnet, dass** die erste Beziehung lautet:

$$0,9 \le \frac{T^{2a} \cdot \rho_{th}^{2a} + T^{2b} \cdot \rho_{th}^{2b}}{T^7 \cdot \rho_{th}^7} \le 1,1$$

worin:

T$^{2a}$ die Dicke des ersten Musters (2a) ist
T$^{2b}$ die Dicke des zweiten Musters (2b) ist
$\rho_{th}^{2a}$ die Wärmeleitfähigkeit des das erste Muster (2a) bildenden Materials ist
$\rho_{th}^{2b}$ die Wärmeleitfähigkeit des das zweite Muster (2a) bildenden Materials ist
T$^7$ die Dicke des Heizelements (7) ist
$\rho_{th}^7$ die Wärmeleitfähigkeit des Heizelements (7) ist.

9. Verfahren nach einem der Ansprüche 7 und 8, **dadurch gekennzeichnet, dass** die zweite Beziehung lautet:

$$T_R - T_J = R_{el}^{2a} \cdot R_{th}^{2a} \cdot I_R \cdot I_R$$

mit

T$_R$ der Temperatur der Grenzfläche zwischen dem Heizelement (7) und dem ersten Muster (2a);
T$_J$ der Temperatur des elektrischen Übergangs (5);
$R_{el}^{2a}$ dem elektrischen Widerstand des ersten Musters (2a);
$R_{th}^{2a}$ dem Wärmewiderstand des ersten Musters (2a);
$I_R$ dem in der Speicherzelle fließenden Strom.

10. Verfahren nach einem der Ansprüche 7 bis 9, **dadurch gekennzeichnet, dass** die dritte Beziehung lautet:

$$T_R - T_O = R_{ON}^S \cdot R_{th}^{II} \cdot I_R \cdot I_R$$

mit

T$_R$ der Temperatur der Grenzfläche zwischen dem Heizelement (7) und dem ersten Muster (2a);
T$_O$ der an den Anschlüssen der Zelle vorliegenden Temperatur;
$R_{ON}^S$ dem elektrischen Widerstand der Zelle;
$R_{th}^{II}$ dem äquivalenten Wärmewiderstand des Heizelements (7), das zu den in Reihe geschalteten ersten Muster (2a) und zweiten Muster (2b) parallel geschaltet ist;
$I_R$ dem in dem Speicher fließenden Strom.

**Claims**

1. Memory cell (1) comprising:

    - a first pattern (2a) made of a first phase-change material of a first conductivity type, the first pattern (2a) having a first thermal resistance value,
    - a second pattern (2b) made of a second phase-change material of a second conductivity type, the second pattern (2b) having a second thermal resistance value, the first and second patterns (2a, 2b) being arranged to form an electric p/n-type junction located between two electrodes, the junction being located at the interface between the first and second patterns (2a, 2b) in an area where both patterns are polycrystalline,
- a heating element (7) connected to the first pattern (2a), the heating element (7) being separated from the second pattern (2b) by the first pattern (2a), the heating element (7) having a third thermal resistance value,
- a phase-change memory area (3) formed in electrical contact with the heating element (7) in a portion of the first pattern (2a),

memory cell (1) **characterized in that** the second material of the second pattern (2b) is made of a phase-change material, and **in that** the ratio of the thermal resistance of the heating element (7) and the sum of the thermal resistances of the first pattern (2a) and the second pattern (2b) is ranging between 0.9 and 1.1,

2. Memory cell according to claim 1, **characterized in that** the first pattern (2a) and the second pattern (2b) are made of the same phase-change material.

3. Memory cell according to claim 1 or 2, **characterized in that** it comprises a circuit for applying a first current configured to melt the first phase-change material.

4. Memory cell according to any one of claims 1 to 3, **characterized in that** it comprises a circuit for applying a second current configured to cause the crystallization of the first phase-change material.

5. Memory cell according to any one of claims 1 to 4, **characterized in that** the phase-change pattern (2) is formed by elementary layers of phase-change materials having different compositions.

6. Memory cell according to any one of claims 1 to 5, **characterized in that** the thicknesses of the heating element (7), of the first phase-change material pattern (2a), and of the second phase-change material pattern (2b) are configured to fulfill the following equation:

$$0.9 \leq \frac{T^{2a} \cdot \rho_{th}^{2a} + T^{2b} \cdot \rho_{th}^{2b}}{T^7 \cdot \rho_{th}^7} \leq 1.1,$$

where:

$T^{2a}$ is the thickness of the first pattern (2a)
$T^{2b}$ is the thickness of the second pattern (2b)

$\rho_{th}^{2a}$ is the thermal conductivity of the material forming the first pattern (2a)

$\rho_{th}^{2b}$ is the thermal conductivity of the material forming the second pattern (2b)
$T^7$ is the thickness of the heating element (7)

$\rho_{th}^7$ is the thermal conductivity of the heating element (7).

7. A method for sizing a phase-change memory cell (1) successively comprising, along a first axis, a heating element (7), a first pattern (2a) of a first phase-change material, a second pattern (2b) of a second phase-change material, the first and second patterns forming a p/n junction (5) at an area where both materials are polycrystalline, a phase-change memory area (3) being formed in contact with the heating element (7) in a portion of the first pattern (2a), the method comprising:

- defining a first relation between dimensions of the first pattern (2a), of the second pattern (2b), and of the heating element (7) to have a ratio of a thermal resistance of the heating element (7) to the sum of a thermal resistances of the first pattern (2a) and of the second pattern (2b) along the first axis ranging between 0.9 and 1.1,
- defining a second relation between the dimensions of the first pattern (2a), a current flowing through the memory cell (1), a temperature of the junction (5), and a temperature of the interface between the heating element (7) and the first pattern (2a) according to electrothermal equivalence principle,
- defining a third relation between dimensions of the first pattern (2a), of the second pattern (2b), dimensions of the heating element (7), the current flowing through the memory cell (1), a temperature across the memory cell (1), and the temperature of the interface between the heating element (7) and the first pattern (2a) according to electrothermal equivalence principle,
- expressing the temperature of the junction (5) according to the temperature across the memory cell (1), to the current flowing across the heating element (7), to dimensions of the first pattern (2a), dimensions of the second pattern (2b), and dimensions of the heating element (7) based on the first, second, and third relations.

8.  The method according to claim 7, wherein the first relation is:

$$0.9 \leq \frac{T^{2a} \cdot \rho_{th}^{2a} + T^{2b} \cdot \rho_{th}^{2b}}{T^7 \cdot \rho_{th}^7} \leq 1.1,$$

where

$T^{2a}$ is the thickness of the first pattern (2a)
$T^{2b}$ is the thickness of the second pattern (2b)
$\rho_{th}^{2a}$ is the thermal conductivity of the material forming the first pattern (2a)
$\rho_{th}^{2b}$ is the thermal conductivity of the material forming the second pattern (2b)
$T^7$ is the thickness of the heating element (7)   $\rho_{th}^7$ is the thermal conductivity of the heating element (7).

9.  The method according to claim 7, wherein the second relation is:

$$T_R - T_J = R_{el}^{2a} \cdot R_{th}^{2a} \cdot I_R \cdot I_R \quad ,$$

where

$T_R$ is the temperature of the interface between the heating element (7) and the first pattern (2a);
$T_J$ is the temperature of the electric junction (5);
$R_{el}^{2a}$ is the electric resistance of the first pattern (2a);
$R_{th}^{2a}$ is the electric resistance of the second pattern (2a);
$I_R$ is the current flowing through the memory cell (1).

10.  The method according to claim 7, wherein the third relation is:

$$T_R - T_O = R_{ON}^S \cdot R_{th}^{//} \cdot I_R \cdot I_R \quad ,$$

where

$T_R$ is the temperature of the interface between the heating element (7) and the first pattern (2a);
$T_O$ is the temperature present across the cell (1);
$R_{ON}^S$ is the electric resistance of the cell (1);
$R_{th}^{//}$ is the equivalent electric resistance of the heating element (7) assembled in parallel with series-assembled first pattern (2a) and second pattern (2b) ;
$I_R$ is the current flowing through the memory.

Figure 1 (Art antérieur)

Figure 2

Figure 3

Figure 4

RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 2011155984 A1

**Littérature non-brevet citée dans la description**

- **REINHARD et al.** Properties of chalcogenide glass-silicon heterojunctions. *Appl. Phys. Lett.,* 1973, vol. 23 (4
- **DIETER K. SCHROEDER.** Semiconductor Material Device Characterization. Wiley-Interscience, 17 Juin 1998
- **D.G. CAHILL et al.** *J. Appl. Phys.,* 2003, vol. 93, 793